Europäisches Patentamt

(19) European Patent Office

Office européen des brevets

(11) Publication number : **0 455 408 A1**

# (12) EUROPEAN PATENT APPLICATION

(21) Application number : **91303681.0**

(22) Date of filing : **24.04.91**

(51) Int. Cl.⁵ : **C23C 14/56, C23C 14/06, C23C 14/34**

(30) Priority : **01.05.90 GB 9009742**

(43) Date of publication of application :
**06.11.91 Bulletin 91/45**

(84) Designated Contracting States :
**AT BE CH DE DK FR IT LI NL SE**

(71) Applicant : **UNITED KINGDOM ATOMIC ENERGY AUTHORITY**
**11 Charles II Street**
**London SW1Y 4QP (GB)**

(72) Inventor : **Cook, John**
**40 Crafts End**
**Chilton, Didcot, Oxfordshire (GB)**
Inventor : **Rickerby, David Stafford**
**11 Chevin Road**
**Duffield, Derbyshire (GB)**
Inventor : **Warrington, Philip**
**48 North Drive**
**Harwell, Oxfordshire (GB)**

(74) Representative : **Wood, Paul Austin et al**
**United Kingdom Atomic Energy Authority**
**Patents Branch B329 Harwell Laboratory**
**Oxfordshire OX11 0RA (GB)**

(54) Coating of filaments by sputter-ion-plating.

㊐ A process for coating the surface of a fibre for use in a metal matrix composite material in which the fibre is drawn continuously through a plasma discharge in a hollow cathode electrode the inner wall of which at least is made of a material to be deposited on the fibre.

EP 0 455 408 A1

The present invention relates to the production of coated fibres for use in the manufacture of metal matrix composite materials.

It is known, for example see GB Patent Specifications 1,386,551 and 1,560,110, to produce coatings on a fibre for use in the manufacture of metal matrix composites by drawing a fibre continuously through a reaction chamber in which deposition of the coating material takes place by chemical vapour deposition. It is known also that one can deposit materials by means of the process known as sputter ion plating in which material is sputtered from a source by energetic particles, ionised and deposited on a suitably charged workpiece.

The present invention provides a method and apparatus for the deposition of a coating upon an electrically conducting substrate in the form of a fibre, the method comprising the operation of drawing an electrically conducting fibre upon which a coating is to be deposited by sputter ion plating continuously through a plasma discharge contained within a hollow cathode electrode the inner wall of which is made of a material to be deposited upon the fibre.

The apparatus comprises a vacuum chamber, a cylindrical electrode positioned within the vacuum chamber and adapted to act as a hollow cathode the inner surface of which is made of a material to be deposited upon an electrically conducting substrate fibre, means for establishing a plasma discharge within the hollow cathode thereby to cause charged species to be sputtered from the wall of the hollow cathode, means for applying a potential to the fibre and means for passing the fibre continuously through the plasma discharge within the hollow cathode.

There may be included more than one such electrode positioned sequentially and made of different materials so that multi-layer coatings can be deposited upon the fibre.

The invention will now be described, by way of example, with reference to the accompanying schematic drawing of an apparatus embodying the invention.

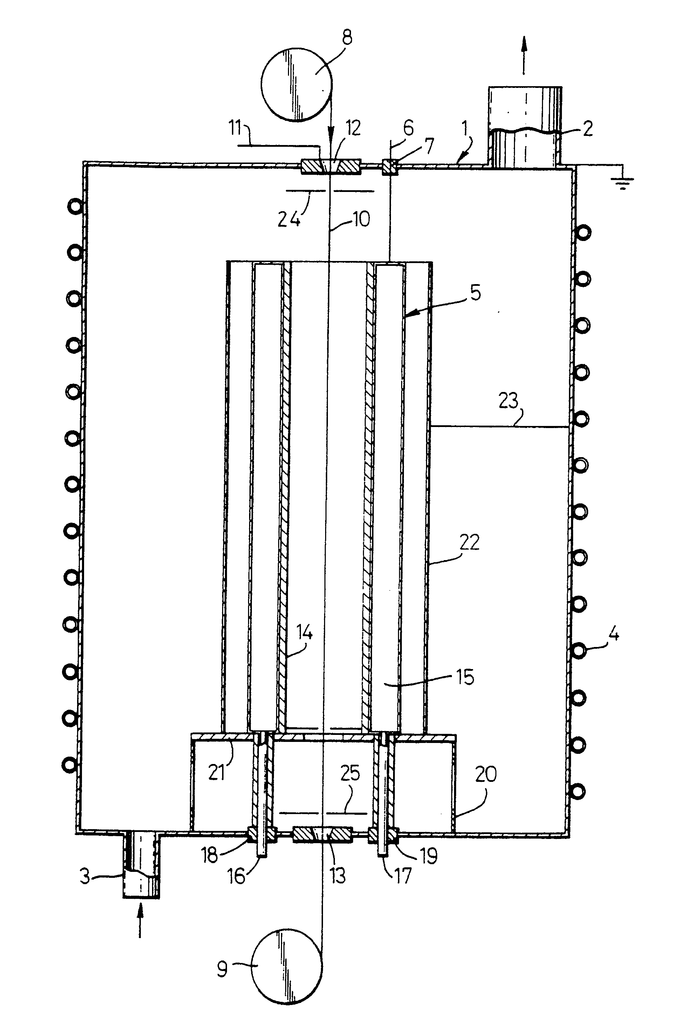

Referring to the drawing, an apparatus for coating a silicon carbide fibre by means of sputter ion plating comprises a vacuum chamber 1 which may be exhausted by means of a vacuum pump (not shown) and a port 2. There is provided also a port 3 by means of which an inert, plasma forming gas may be admitted to the vacuum chamber 1. Surrounding the vacuum chamber 1 is a cooling water coil 4. Within the vacuum chamber 1 is a cylindrical electrode 5 which is connected to the outside of the vacuum chamber 1 by a connection 6 and an insulating feed through 7, by means of which a negative potential can be applied to the electrode 5 thus enabling it to act as a hollow cathode. Also provided are feed and take-up spools 8 and 9, respectively, for a silicon carbide, or other substrate fibre 10. There is provided also, but not shown, means for applying a positive or alternating potential to the fibre 10 via a connection 11 and mercury gas seals and feed-throughs 12 and 13 to assist in the sputter ion plating process.

The inner wall 14 of the cathode electrode 5 is made of the material to be deposited upon the fibre 10. The inner wall 14 of the electrode 5 is surrounded by a water cooling jacket 15. Inlet and outlet pipes 16 and 17 enable cooling water to be circulated around the inner wall 14 of the cathode electrode 5. The inlet and outlet pipes 16 and 17 pass through insulated lead-throughs 18 and 19, respectively. The cathode electrode 5 is mounted on a support 20 which has an insulating upper surface 21. The cathode electrode 5 is surrounded by an electrical shield 22 which is earthed via a connection 23 to the vacuum chamber 1, which is itself earthed. Shields 24 and 25 prevent coating material from being deposited upon the inner surfaces of the gas seal/lead-throughs 12 and 13. In practice the inner-wall 14 of the cathode electrode 5 may be made in the form of separate plates of different materials which can be energised independently, so enabling the composition of the deposited coating to be varied. For example the electrode 5 may be made of alternate plates of titanium and carbon so that a coating of varying non-stoichiometry may be deposited upon a fibre 10 made of silicon carbide.

There may also be provided more than one electrode 5 positioned so that the fibre 10 passes through them sequentially so that multi-layer coatings can be deposited upon the fibre 10.

In use, the vacuum chamber 1 is evacuated to about $10^{-3}$ torr and heated by means, not shown to assist in the out-gassing of the interior of the vacuum chamber 1. When the interior of the vacuum chamber 1 has been out-gassed, an operating inert gas such as argon or helium, to enable a glow discharge to be set up within the electrode 5 is admitted. Suitable pressures are in the range $10^{-1}$ to $1.5 \times 10^{-1}$ torr and suitable cathode potentials are in the range 300 - 900 volts.

The diameter and length of the electrode 5; the operating gas pressures and the power input levels are determined by the deposition rate and the thickness of the coating on the fibre 10 required. Appropriate empirical optimisation of the bore of the electrode 5, its diameter and temperature, the plasma gas pressure and the temperature and potential of the fibre 10 enable the input power and so deposition rate, to be optimised.

For example, using a power input level of about 1 kW with a water cooled titanium electrode 5 having a bore of 22 mm and length of about 200 mm, a mean deposition rate of about $1.13 \times 10^{-4}$ gm mm$^{-1}$ kW hr$^{-1}$ onto a silicon carbide fibre of about 150 μm diameter at a mean peak gas plasma temperature of about 750°C was achieved. This corresponded to a deposition rate of about 1.5 μm min$^{-1}$.

At a power input of between 200 and 250 watts, a transfer rate of titanium from the electrode 5 to the fibre 10 of about 0.03 gms/hr was achieved. The fibre 10 had a diameter of about 100 μm and the transfer rate corresponded to a coating thickness of some 65 μm.

## Claims

1. A method of depositing a coating upon an electrically conducting substrate in the form of a fibre, comprising the operations of establishing a plasma discharge within a hollow cylindrical electrode the walls of which are made of a material to be deposited upon the fibre thereby to sputter charged species from the inner wall of the electrode and drawing the fibre continuously through the plasma discharge thereby to cause coating material from the plasma to be deposited upon the fibre.

2. A method according to Claim 2 wherein a potential is applied to the fibre to assist the deposition of the material from the plasma.

3. A method according to Claim 1 or Claim 2 wherein a plasma forming inert gas is introduced into the region within the hollow electrode.

4. A method according to Claim 3 wherein the plasma forming inert gas is argon.

5. A method according to any preceding claim wherein the fibre is a monifilament of silicon carbide.

6. A method according to Claim 5 wherein the hollow cylindrical electrode is made of titanium.

7. A method according to Claim 5 wherein the electrode is made of alternate plates of titanium and carbon and they are energised separately thereby to enable titanium carbide of differing non-stoichiometric composition to be deposited upon the silicon carbide fibre.

8. An apparatus for the deposition of a coating upon an electrically conducting fibre by means of sputter ion plating, comprising, a vacuum chamber, means for evacuating the vacuum chamber, means for admitting a plasma forming gas to the vacuum chamber, a cylindrical hollow electrode positioned within the vacuum chamber and adapted in use to act as a cathode electrode the inner surface of which is made of a material to be deposited- upon an electrically conducting fibre, means for establishing a plasma discharge within the hollow cathode thereby to cause material to be sputtered from the wall of the hollow cathode, means for applying a potential to the fibre and means for passing the fibre continuously through the plasma discharge within the hollow cathode.

9. Apparatus according to Claim 8 where there is provided a plurality of hollow cathodes so positioned that the fibre can be passed through them sequentially thereby enabling multi-layer coatings to be deposited upon the fibre.

10. Apparatus according to Claim 8 or Claim 9 wherein one or more of the hollow cathodes is made of plates of different materials and there is provided means for energising the plates of different materials seperately thereby to enable coatings of different non-stoichiometric constitution to be deposited upon the fibre.

11. An apparatus according to any of Claims 8 to 10 including means for controlling the temperature of the cathode electrode.

12. An apparatus according to Claim 11 wherein the means for controlling the temperature of the cathode electrode comprises a water jacket.

13. A method of depositing a coating upon an electrically conducting fibre substantially as hereinbefore described.

14. An apparatus for the deposition of a coating upon an electrically conducting fibre substantially as hereinbefore described and with reference to the accompanying drawing.

European Patent Office

**EUROPEAN SEARCH REPORT**

Application Number

EP 91 30 3681

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-4 863 576 (COLLINS ET AL.) <br><br> * claims 1,8,16-18,23 * | 1,3,4, 6-9, 11-14 | C23C14/56 <br> C23C14/06 <br> C23C14/34 |
| A | GB-A-2 219 006 (ROLLS ROYCE) <br> * claims 1-3 * | 1,5 | |

TECHNICAL FIELDS SEARCHED (Int. Cl.5 )

C23C

The present search report has been drawn up for all claims

| Place of search | Date of completion of the search | Examiner |
|---|---|---|
| THE HAGUE | 08 AUGUST 1991 | PATTERSON A.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)